(19) Europäisches Patentamt / European Patent Office / Office européen des brevets

(11) **EP 1 681 766 B1**

(12) **EUROPEAN PATENT SPECIFICATION**

(45) Date of publication and mention of the grant of the patent:
**12.03.2014 Bulletin 2014/11**

(51) Int Cl.:
**H03H 17/02** *(2006.01)*  **H03H 17/06** *(2006.01)*

(21) Application number: **06300003.8**

(22) Date of filing: **02.01.2006**

(54) **Sample rate converter**

Abtastratenumsetzer

Convertisseur de fréquence d'échantillonage

(84) Designated Contracting States:
**DE FR GB**

(30) Priority: **13.01.2005 EP 05000549**

(43) Date of publication of application:
**19.07.2006 Bulletin 2006/29**

(73) Proprietor: **Thomson Licensing**
**92130 Issy-les-Moulineaux (FR)**

(72) Inventors:
• **Lo Muzio, Pierluigi**
  **85622, Feldkirchen (DE)**
• **Schemmann, Heinrich**
  **78052, Villingen-Schwenningen (DE)**

(74) Representative: **Thies, Stephan**
**Deutsche Thomson OHG**
**European Patent Operations**
**Karl-Wiechert-Allee 74**
**30625 Hannover (DE)**

(56) References cited:
**US-A- 5 666 299**

• **ADAMS R ET AL: "A STEREO ASYNCHRONOUS DIGITAL SAMPLE-RATE CONVERTER FOR DIGITAL AUDIO" IEICE TRANSACTIONS ON ELECTRONICS, ELECTRONICS SOCIETY, TOKYO, JP, vol. E77-C, no. 5, 1 May 1994 (1994-05-01), pages 811-818, XP000459521 ISSN: 0916-8524**

## Description

This invention relates to electronic devices, in particular to circuitry and methods for the conversion of digitally sampled data. The invention can be used in all fields in which the sample rate of a stream of data has to be changed, and particularly in audio systems and video systems. Another application is the adaptation of the sampling rate of the base band signal to the high sampling rate of a digital modulator in a telecommunication system, e.g. ADSL.

Digitally sampling analog signals such as audio signals or video signals is generally known. When processing the sampled signals it is often desirable to mix sampled data having different sample rates. For that purpose a sample rate conversion is necessary in which the sampled signal is converted from a first sample rate to a second sample rate. As an example, audio signals are often sampled at rates of 11.025, 22.05 or 44.1 KHz, or at rates of 8, 16, 32, or 48 KHz. Converting a signal from 8 KHz to 11.025 KHz means applying a sampling factor of 441/320, which needs complex converters in order to avoid a degradation of the signal quality.

Sample rate converters can be categorized in synchronous sample rate converters and asynchronous sample rate converters. In the first case the sampling factor, which is the ratio of the output sampling rate and the input sampling rate, is a rational number such as 441/320. In the latter case the ratio cannot be expressed by a rational number.

US 5,907,295 discloses a synchronous sample rate converter (SSRC). The SSRC being used is a two-stage converter. A first stage is an L-tap low-pass FIR, and the second stage is a linear interpolator. The first stage adjusts the sampling rate by a factor of $Q_0/P_0$ and the second stage by a factor of $Q_1/P_1$, such that the overall sampling factor is $Q/P = Q_0/P_0 * Q_1/P_1$. Splitting the SSRC into two stages results in a decreased coefficient storage within the L-tap FIR. This SSRC is not suitable for sampling factors smaller than 1/8, or sampling factors larger than 8. Its performance in terms of signal to noise ratio (SNR) is also limited.

US 5,666,299 discloses an asynchronous sample rate converter (ASRC). The number of filter coefficients stored in a ROM are reduced by the design of the ASRC. This ASRC is not suitable for sampling factors smaller than 1/8, or sampling factors larger than 8. Its SNR is also limited.

US 5,638,010 discloses a digitally controlled oscillator (DCO) in a digital phase lock loop, for the synchronization of ASRCs with a high sampling factor. For this purpose, the DCO generates a suited clock signal. It also generates a residue signal, usable for the precise interpolation of data samples. This residue signal is related to the instantaneous phase of the DCO.

In " A Stereo Asynchronous Digital Sample-Rate Converter for Digital Audio", IEICE Transactions on Electronics, Institute of Electronics Information And Comm. Eng. Tokyo, JP, vol. E77-C (1994), no. 5, pp. 811-818, Adams et al. disclose an asynchronous sample rate converter including an n-tap polyphase filter (2), with n being an integer, and a computational entity (5,9) for calculating the filter coefficients.

It is an object of the invention to provide a high-performance ASRC and a corresponding method for converting a sample rate from a first value to a second value. The ASRC and the method should be usable for oversampled input signals and for very high or very low sampling factors of the converter.

According to the present invention the above-mentioned objects are achieved by providing the features defined in the independent claims. Preferred embodiments according to the invention additionally comprise the features defined in the sub-claims. It should be emphasized that any reference signs in the claims shall not be construed as limiting the scope of the invention.

According to the present invention the above-mentioned objects are achieved by an asynchronous sample rate converter as defined in claim 1.

The corresponding method is a method for asynchronously converting the sample rate of digitally sampled data from a first sample rate to a second sample rate as defined in claim 6.

These and other aspects of the invention will be apparent from and elucidated with reference to the embodiments described thereafter.

## Brief description of the drawings

Fig. 1    shows the ASRC with a reduced computational complexity,

Fig. 2    shows the Parzen window, the quadratic window, and (for comparison reasons) the triangular window in the frequency domain,

Fig. 3    shows the first five notches of a Parzen window and a quadratic window,

Fig. 4    shows the first notch of a Parzen window and a quadratic window in more detail,

Fig. 5     a circuit exampling the generation of filter coefficients in the case of a quadratic window,

Fig. 6     a circuit exampling the generation of filter coefficients in the case of a Parzen window,

Fig. 7     a circuit comprising the ASRC of Fig. 1.

**Detailed description of the drawings and description of the preferred embodiments.**

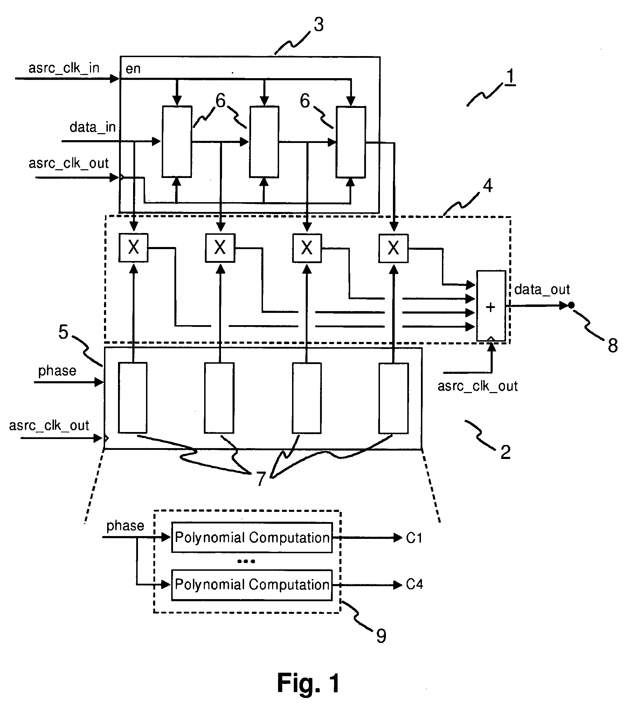

Fig. 1 schematically shows the ASRC 1 according to the invention. It comprises a 4-tap polyphase filter 2 which comprises a delay pipeline 3 and a digital signal processor (DSP) 4. The clock signal ascr_clk_in enables the delay pipeline 3 and clocks input data data_in sequentially through data registers (or flip-flops) 6, such that the utmost left register contains the newest sample, and the utmost right register the oldest sample.

The clock signal asrc_clk_in is in general a jittered clock because it is phase synchronous with asrc_clk_out and frequency synchronous with data_in. Typically this clock is generated by means of the DCO of a digital PLL. This DCO uses the same clock signal asrc_clk_out, which synchronizes all registers 6.

The ASRC 1 can be conveniently used when the input data data_in are represented by an oversampled signal. For the purposes of this disclosure an oversampled signal shall be understood to be a signal having a sample rate significantly higher than the minimum sampling rate $F_{MIN}$. Taking the Nyquist theorem into account the minimum sampling rate $F_{MIN}$ is twice the bandwidth.

Filtering is performed by averaging the sample points from the data registers 6. The sample points are multiplied by the DSP 4 with their corresponding weighing/filter coefficients. The sum of all weighted sample points is outputted by the DSP 4 at an output port 8.

In Fig. 1 the n-tap filter 2 (n is an integer) has four taps. The invention however is not restricted to a case of four taps. n may be chosen to be 2, 3, 4 ,...up to 10 or more.

There are two ways of generating the filter coefficients.

The first possibility is the generation of the filter coefficients by a computational entity, whereby the computational entity is at a location external to the n-tap polyphase filter 2. This computational entity might be hardware such as a DSP or an application-specific integrated circuit (ASIC), or may be a computer program running on a remote computer.

The second possibility is the generation of the filter coefficients by a computational entity, whereby the computational entity is at a location inside the n-tap polyphase filter 2. In other words the computational entity is part of the n-tap polyphase filter 2. In this case the computational entity is the coefficient generator 5 of Fig. 1. Advantageously, the coefficient generator 5 has a limited complexity when the input signals are oversampled signals.

When the first possibility is chosen the n-tap polyphase filter has to provide memory space for the filter coefficients which are generated externally (outside the n-tap polyphase filter). In this case the phase signal is used as the reading address of four independent memory units 7, whereby each memory unit 7 of block 5 holds all the $2^P$ possible values of a specific coefficient, with P = number of bits of the phase signal. For a precise interpolation, for instance with P=9, the required memory in block 5 is $2^9*4$ words. As can be derived from the above explanations, block 5 is a pure memory block in this (first) operation mode. Block 9 can be regarded as the external computational entity.

When the second possibility is chosen, the phase signal is used for the polynomial computation of the filter coefficients by means of a computational entity 5. Typically the phase signal is generated by the DCO of a digital PLL. The four coefficients are $C_l = A_l * l + B_l * l^2 + C_l * l^3 + D_l * l^3$, whereby l is an index ranging from 1 to 4, and whereby I is the input phase signal.
The coefficients are either calculated on the fly (online calculation), or have been preloaded (offline calculation).

When the second possibility for generating the filter coefficients is chosen the calculation of the filter coefficients is performed in block 5. In this (second) operation mode block 5 is a coefficient generator or computational entity. Details of block 5 serving as a computational entity is visualized by means of block 9. It should be emphasized however that block 9 is merely a representation of block 5, and is not a separate physical entity. Block 9 thus zooms into block 5. The constants $A_l$, $B_l$, $C_l$, $D_l$ etc. are retrieved from a small memory unit (not shown). In this example a third order polynomial is chosen, such that a total of 16 coefficients are stored, whereby each coefficient needs a memory space of only 4 words. This solution for the coefficient generator reduces the required memory at the expenses of additional polynomial computations and it is generally better when a very precise interpolation is needed.

The invention uses the Parzen window or the quadratic window as the polynomial smart window. The Parzen window, also referred to as the de la Valle Poussin window, is a third order polynomial and is defined as

$$w(n) = 1 - 6 \cdot \left(\frac{n}{N/2}\right)^2 \cdot \left(1 - \frac{|n|}{N/2}\right) \qquad 0 \le |n| \le N/4$$

$$w(n) = 2 \cdot \left(1 - \frac{|n|}{N/2}\right)^3 \qquad N/4 \le |n| \le N/2$$

whereby n is the index of the time samples, and N+1 is the total length of the window. In the alternative, a quadratic window is chosen. This is a second order polynomial which is defined as

$$w(n) = 1 - 2 \cdot \left(\frac{n}{N/2}\right)^2 \qquad 0 \le |n| \le N/4$$

$$w(n) = 2 \cdot \left(1 - \frac{|n|}{N/2}\right)^2 \qquad N/4 \le |n| \le N/2$$

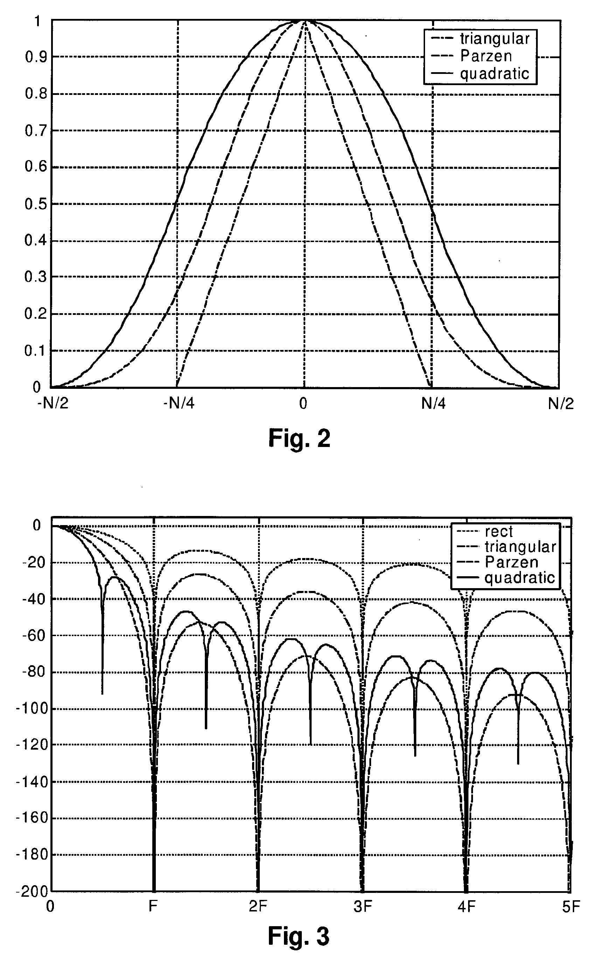

Both windows are shown in the time domain in Fig. 2, whereby the y-coordinate is normalized to 1. In addition, a triangular window is shown, which is basically known from the prior art. The curves stem from (from top to bottom) the quadratic window, the Parzen window, and the triangular window. The advantage of this second order or third order polynomial are repetitive notches of the prototype filter in the frequency domain with a particularly a high attenuation to avoid aliasing.

Both windows show a better performance (as far as the attenuation at the repetitive notches is concerned) when compared to a triangular window or to a rectangular window. As far as the above mentioned attenuation is concerned the Parzen window is even better than the quadratic window. The performance of the quadratic window is between the Parzen window and the triangular window.

The quadratic window is a smart window because it shows a double symmetry: an even symmetry around y=0, and an odd symmetry around (-N/4, 0.5) and (N/4, 0.5). The latter symmetry is useful when a multiple of four samples are used, because in this case half of the samples can be computed without other multiplications, applying a simple subtraction.

Fig. 3 shows the first five lobes of a Parzen window and a quadratic window in the frequency domain. For comparison purposes, the rectangular window and the triangular window are shown as well. When looking on the second lobe, the curves stem from (from top to bottom) the rectangular window, the triangular window, the quadratic window having two maxima, and the Parzen window. The y-axis denotes the attenuation in units of dB, and the x-axis is divided in units of F. F denotes the sampling frequency at the input of the ASRC. To make this comparison possible, the duration of the quadratic window and the Parzen window are doubled to get the first notch in the frequency domain at the proper frequency. The doubled duration implies a double number of taps: 4 taps for the Parzen window and the quadratic window, 2 taps in the case of the triangular window, and only 1 tap in the case of the rectangular window. The first notch is the most important notch as the attenuation is increased in the other notches. As can be seen, the attenuation for the Parzen window and the quadratic window is particularly high as desired.

Another advantage of the quadratic window is that it creates secondary notches at middle frequencies. This means that the over-sampling stage enjoys an additional stop-band attenuation.

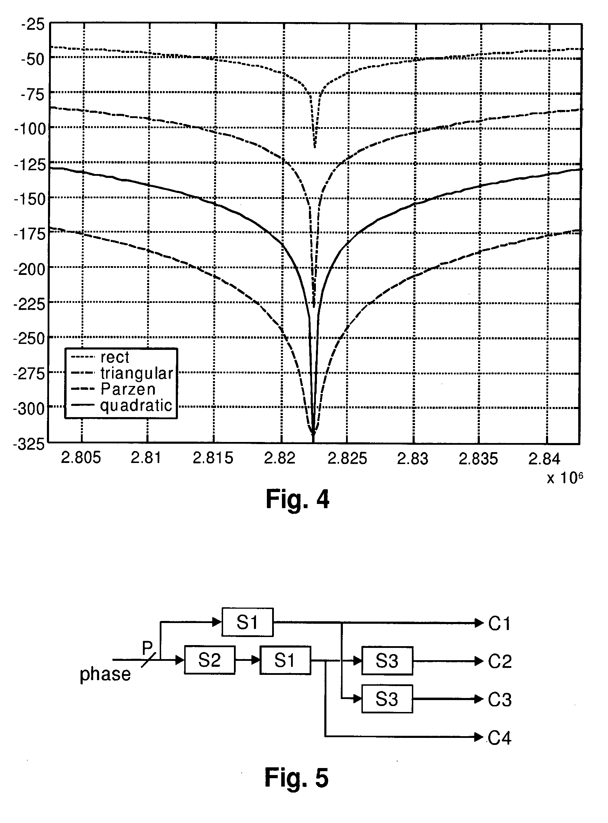

Still another advantage of the Parzen window and the quadratic window is that their dips in the frequency domain are particularly wide, such that bandwidth requirements at notch frequencies can be easily satisfied. This can be seen with the help of Fig. 4, in which the attenuation in dB is plotted versus the frequency in Hertz. The curves stem from (from top to bottom) the rectangular window, the triangular window, the quadratic window, and the Parzen window. The quadratic window attenuates at least - 125 dB in the whole bandwidth. This satisfies the specification of 16 bit audio with a large margin. 20 bit audio is satisfied with a small margin. The Parzen window is even better, such that it is particularly well suited for high-end applications of digital audio. For comparison, the first notch of the rectangular window and the triangular window, both used in the prior art, are shown as well. Their attenuation within the bandwidth of +/- 20 KHz is much poorer such that a compensation is needed.

The above formulae of the Parzen window and the quadratic window cannot be used directly to compute the filter coefficients by using the phase signals, whereby the phase signal might be provided by a DCO. In the case of the quadratic window, the coefficients C1, C2, C3 and C4 are computed as follows:

$$C_1 = k \cdot \varphi^2$$

$$C_2 = k \cdot \left(2 \cdot (\tfrac{N}{4})^2 - (\tfrac{N}{4} - \varphi)^2\right)$$

$$C_3 = k \cdot \left(2 \cdot (\tfrac{N}{4})^2 - \varphi^2\right)$$

$$C_4 = k \cdot (\tfrac{N}{4} - \varphi)^2$$

k is a constant which determines the filter gain, $\varphi$ is the phase signal from the DCO, $\tfrac{N}{4} = 2^P$, whereby P is the number of bits of the phase signal from the accumulator of the DCO.

In the case of the Parzen window, the coefficients are computed as follows:

$$C_1 = k \cdot \varphi^3$$

$$C_2 = k \cdot \left(4 \cdot (\tfrac{N}{4})^3 - 3 \cdot (\tfrac{N}{4} + \varphi) \cdot (\tfrac{N}{4} - \varphi)^2\right)$$

$$C_3 = k \cdot \left(4 \cdot (\tfrac{N}{4})^3 - 3 \cdot (\tfrac{N}{2} - \varphi) \cdot \varphi^2\right)$$

$$C_4 = k \cdot (\tfrac{N}{4} - \varphi)^3$$

Fig. 5 shows a circuit which exemplifies the generation of filter coefficients in the case of a quadratic window. If I is the input signal of each block, step S1 computes $I^2$, and outputs this value as the filter coefficient C1. Step S2 computes $2^P$-I and step S3 computes $2^{2*P-1}$ -I. The constant k has been omitted because its value depends on the specific gain to be obtained in the filter. No memory is needed as all coefficients are calculated on the fly by simple operations. Neglecting trivial shifts and simple additions or subtractions, only two multipliers or square operations are needed.

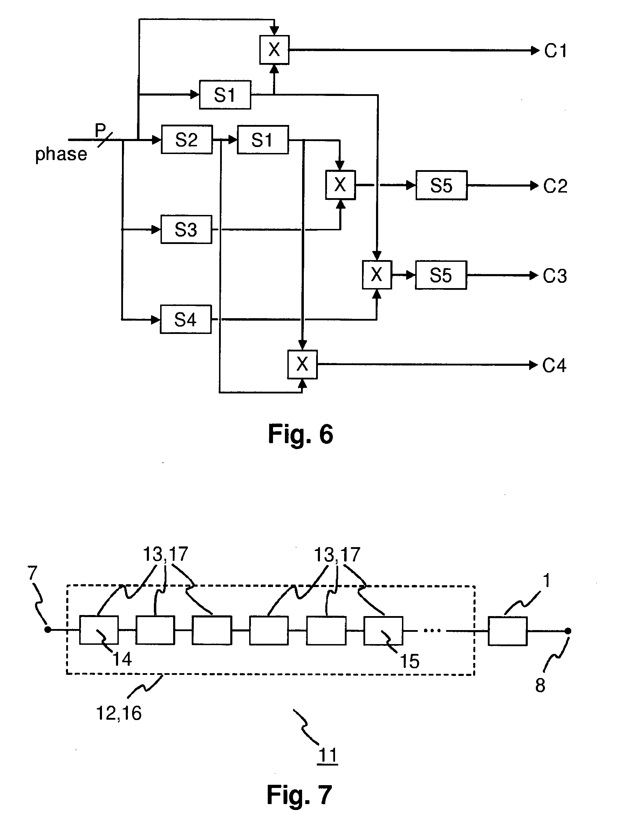

Fig. 6 shows a circuit which exemplifies the generation of filter coefficients in the case of a Parzen window. In addition to steps S1 and S2 there are additional computation steps S3, which computes $2^P+1$, S4, which computes $2^{P+1}+1$, and S5, which computes $2^{3P+2}$-3*I.

Fig. 7 schematically shows the use of the ASRC 1 of the present invention and its particular advantages to convert the sample rate of digitally sampled data to a much higher or much lower sampling rate.

Circuit 11 has an input port 7 for input signals having a first sample rate, and an output port 8 for signals having a second sample rate. In this case the input data at port 7 are not oversampled like data_in of Fig.1. Instead, the whole converter 11 provides a sampling factor which is higher than 8 or lower than 1/8.

Circuit 11 consists of an interpolation stage 12 with an integer sampling factor and an ASRC 1 as explained above. The interpolation stage 12 may be chosen to be composed of interpolation units 13, whereby each interpolation unit interpolates by a factor of 2. Splitting the interpolation stage 12 into a couple of interpolation units, whereby each

EP 1 681 766 B1

interpolation unit interpolates by a factor of 2, has the advantage that the overall design of the circuit 11 becomes simpler. All interpolation units 13 are connected in series. The first interpolation unit 14 is connected to the input port 7, and the last interpolation unit 15 is connected to the ASRC 1. As can be derived from this explanation, the circuit 11 represents an ASRC, being composed of an interpolation stage 12 and a residual ASRC 1.

In the second case the interpolation stage 12 is replaced by a decimation stage 16 with an integer decimation factor (=1/sampling_factor) of at least 4. The decimation stage 16 may be chosen to be composed of decimation units 17, whereby each decimation unit decimates by a factor of 2. All decimation units 13 are connected in series. Furthermore, the residual ASRC 1 is the first stage into which the input signal is fed, and the decimation stage is the second stage outputting the output signal with the second sample rate. In other words port 8 becomes the input port, and port 7 the output port. For reasons of convenience, the following description will not discuss this second case in detail, as the advantages are identical.

The idea of the circuit 11 is to split the ASRC into an interpolation stage 12 with an integer interpolation factor of at least 4 and a residual ASRC. Further advantage is obtained by the split of the stage 12 into multiple interpolation units 13, each one interpolating the sample rate by a factor of 2. The particular advantage of the circuit 11 is that the residual ASRC 1 has to handle a sampling factor which is smaller than without the preceding interpolation stage 12. Therefore the computational burden for the ASRC 1 is decreased. This allows a simpler design for the ASRC 1.

As mentioned above, the ASRC 1 of the present invention is particularly well suited for input signals having a high sampling rate $F/F_{MIN}$ (or low sampling rate in the dual case). A signal with a high sampling rate is provided by the interpolation stage 12 of the circuit 11. The absolute value of $F/F_{MIN}$ which can be chosen mainly depends on two aspects.

One aspect is the design of the circuit 11. On the one hand the design of the ASRC 1 is simplified, and on the other hand the complexity of the circuit 11 is increased by the additional interpolation stage 12. From a practical point of view splitting the total ASRC into an interpolation stage 12 and a residual ASRC 1 may be acceptable if the sampling factor of the interpolation stage 12 is at least 8, such that a separated interpolation by 4 is needed .

A second aspect is the SNR of the ASRC 1 which is acceptable to the user. $F_{IN}$ may denote the input sampling rate of the ASRC 1, $F_{OUT}$ the corresponding output sampling rate, and B may denote the signal bandwidth. The question then is: what is the sampling rate F which must by provided for by the interpolation stage 12 in order to have a desired SNR of the output signal of the ASRC 1, and which window (quadratic or Parzen) should be chosen? Two cases can be distinguished:

   a) if $F_{OUT} > F_{IN} > F_{OUT/2}$ then F is chosen to be $F_{IN}$. In this case no interpolation stage 12 is needed at all. The Parzen window offers a better chance to yield the desired SNR to obtain an attenuation of -SNR dB in the frequency range [F-B, F+B] around F in the first notch of Fig. 3 when compared to the quadratic window.
   b) if $F_{IN} < F_{OUT}/2$ then a trade-off between the complexity of the interpolation stage 12, the complexity of the window, and the required SNR must be found. Generally speaking a higher order window and a higher number of interpolation units improve the SNR. For instance, the maximum number of interpolation units can be chosen till the limit of $F < F_{OUT}$. Then the proper window is selected to satisfy the SNR specification.

**List of reference numerals**

01    ASRC
02    n-tap polyphase filter
03    delay pipeline
04    digital signal processor
05    block
06    data register
07    memory unit
08    output port
09    computational entity
10    input port
11    circuit
12    interpolation stage
13    interpolation unit
14    first interpolation unit
15    last interpolation unit
16    decimation stage
17    decimation unit

**Claims**

1. An asynchronous sample rate converter (1) **comprising:**

   - an input (7) configured to receive an input data signal having a first sample rate,
   - an n-tap polyphase filter (2) configured to filter sample points of the input data signal, with n being an integer larger than 1, and configured to generate an output data signal with a second sample rate,
   - a computational entity (5,9) configured to calculate filter coefficients of the n-tap polyphase filter (2) from an input phase signal by determining a second order polynomial based on a quadratic window from the input phase signal,
   - a digital signal processor (4) within the n-tap polyphase filter (2) configured to generate sample points of the output data signal with the second sample rate, and
   - an output (8) configured to output the output data signal with the second sample rate.

2. The asynchronous sample rate converter (1) according to claim 1, **wherein** n has a value between 2 and 10.

3. The asynchronous sample rate converter (1) according to claim 1, **further** comprising an interpolation stage (12) configured to interpolate the sample rate by an integer factor or a decimation stage (16) configured to decimate the sample rate by an integer factor.

4. The asynchronous sample rate converter (1) according to claim 3, **wherein** the interpolation stage (12) is composed of interpolation units (13), each interpolation unit (13) interpolating by a factor of 2.

5. The asynchronous sample rate converter (1) according to claim 3, **wherein** the decimation stage (16) is composed of decimation units (17), each decimation unit (17) decimating by a factor of 2.

6. A method for asynchronously converting an input data signal having a first sample rate to an output signal having a second sample rate, the method **comprising** the steps of:

   - receiving the input data signal having the first sample rate at an input (7),
   - filtering sample points of the input data signal with an n-tap polyphase filter (2), with n being an integer larger than 1,
   - calculating filter coefficients of the n-tap polyphase filter (2) from an input phase signal with a computational entity (5,9) by determining a second order polynomial based on a quadratic window from the input phase signal,
   - generating sample points of the output data signal with the second sample rate with a digital signal processor (4) within the n-tap polyphase filter (2), and
   - outputting the output data signal with the second sample rate at an output (8).

**Patentansprüche**

1. Asynchroner Abtastratenumsetzer (1), der **umfasst:**

   - einen Eingang (7), der zum Empfangen eines Eingangsdatensignals mit einer ersten Abtastrate konfiguriert ist,
   - ein n-Abgriff-Mehrphasenfilter (2), das zum Filtern von Abtastpunkten des Eingangsdatensignals konfiguriert ist, wobei n eine ganze Zahl größer als 1 ist, und das zum Erzeugen eines Ausgangsdatensignals mit einer zweiten Abtastrate konfiguriert ist,
   - eine Rechenentität (5, 9), die zum Berechnen von Filterkoeffizienten des n-Abgriff-Mehrphasenfilters (2) aus einem Eingangsphasensignal durch Bestimmen eines Polynoms zweiten Grades auf der Grundlage eines quadratischen Fensters aus dem Eingangsphasensignal konfiguriert ist,
   - einen digitalen Signalprozessor (4) innerhalb des n-Abgriff-Mehrphasenfilters (2), der zum Erzeugen von Abtastpunkten des Ausgangsdatensignals mit der zweiten Abtastrate konfiguriert ist, und
   - einen Ausgang (8), der zum Ausgeben des Ausgangsdatensignals mit der zweiten Abtastrate konfiguriert ist.

2. Asynchroner Abtastratenumsetzer (1) nach Anspruch 1, **wobei** n einen Wert zwischen 2 und 10 aufweist.

3. Asynchroner Abtastratenumsetzer (1) nach Anspruch 1, der **ferner** eine Interpolationsstufe (12), die zum Interpolieren der Abtastrate um einen ganzzahligen Faktor konfiguriert ist, oder eine Dezimierungsstufe (16), die zum Dezimieren der Abtastrate um einen ganzzahligen Faktor konfiguriert ist, umfasst.

**4.** Asynchroner Abtastratenumsetzer (1) nach Anspruch 3, **wobei** die Interpolationsstufe (12) aus Interpolationseinheiten (13) besteht, wobei jede Interpolationseinheit (13) um einen Faktor von 2 interpoliert.

**5.** Asynchroner Abtastratenumsetzer (1) nach Anspruch 3, **wobei** die Dezimierungsstufe (16) aus Dezimierungseinheiten (17) besteht, wobei jede Dezimierungseinheit (17) um einen Faktor von 2 dezimiert.

**6.** Verfahren zum asynchronen Umsetzen eines Eingangsdatensignals mit einer ersten Abtastrate in ein Ausgangssignal mit einer zweiten Abtastrate, wobei das Verfahren die folgenden Schritte **umfasst:**

- Empfangen des Eingangsdatensignals mit der ersten Abtastrate bei einem Eingang (7),
- Filtern von Abtastpunkten des Eingangsdatensignals mit einem n-Abgriff-Mehrphasenfilter (2), wobei n eine ganze Zahl größer als 1 ist,
- Berechnen von Filterkoeffizienten des n-Abgriff-Mehrphasenfilters (2) aus einem Eingangsphasensignal mit einer Rechenentität (5, 9) durch Bestimmen eines Polynoms zweiten Grades auf der Grundlage eines quadratischen Fensters aus dem Eingangsphasensignal,
- Erzeugen von Abtastpunkten des Ausgangsdatensignals mit der zweiten Abtastrate mit einem digitalen Signalprozessor (4) innerhalb des n-Abgriff-Mehrphasenfilters (2), und
- Ausgeben des Ausgangsdatensignals mit der zweiten Abtastrate bei einem Ausgang (8).

**Revendications**

**1.** Convertisseur de fréquence d'échantillonnage asynchrone **comprenant :**

- une entrée (7) configurée pour recevoir un signal de données d'entrée présentant une première fréquence d'échantillonnage,
- un filtre polyphase à n prises (2) configuré pour filtrer des points d'échantillonnage du signal de données d'entrée, n étant un entier supérieur à 1 et configuré pour générer un signal de données de sortie avec une seconde fréquence d'échantillonnage,
- une entité computationnelle (5,9) configurée pour calculer
les coefficients de filtre du filtre polyphase à n prises (2) à partir d'un signal de phase d'entrée en déterminant un second ordre polynomial basé sur une fenêtre quadratique à partir du signal de phase d'entrée,
- un processeur de signal numérique (4) dans le filtre polyphase à n prises (2) configuré pour générer des points d'échantillonnage du signal de données de sortie avec la seconde fréquence d'échantillonnage, et
- une sortie (8) configurée pour produire le signal de données de sortie à l'aide de la seconde fréquence d'échantillonnage.

**2.** Le convertisseur de fréquence d'échantillonnage asynchrone (1) selon la revendication 1, **dans lequel** n possède une valeur entre 2 et 10.

**3.** Le convertisseur de fréquence d'échantillonnage asynchrone (1) selon la revendication 1, comprenant **en outre** une étape d'interpolation (12) configurée pour interpoler la fréquence d'échantillonnage par un facteur entier ou une étape de décimation (16) configuré pour décimer la fréquence d'échantillonnage par un facteur entier.

**4.** Le convertisseur de fréquence d'échantillonnage asynchrone (1) selon la revendication 3, **dans lequel** l'étape d'interpolation (12) est composée d'unités d'interpolation (13), chaque unité d'interpolation (13) interpolant par un facteur de 2.

**5.** Le convertisseur de fréquence d'échantillonnage asynchrone (1) selon la revendication 3, **dans lequel** l'étape de décimation (16) est composée d'unités de décimation (17), chaque unité de décimation (17) décimant par un facteur de 2.

**6.** Un procédé de conversion asynchrone d'un signal de données d'entrée présentant une première fréquence d'échantillonnage en un signal de sortie présentant une seconde fréquence d'échantillonnage, le procédé comprenant les étapes suivantes :

- réception du signal de données d'entrée présentant la première fréquence d'échantillonnage à une entrée (7),
- filtrage des points d'échantillonnage du signal de données d'entrée avec un filtre polyphase à n prises (2), n étant un entier supérieur à 1.
- calcul des coefficients de filtre du filtre polyphase à n prises (2) à partir d'un signal de phase d'entrée avec une entité computationnelle (5,9) en déterminant un second ordre polynomial selon une fenêtre quadratique provenant du signal de phase d'entrée,
- génération de points d'échantillonnage du signal de données de sortie avec la seconde fréquence d'échantillonnage avec un processeur de signal numérique (4) dans le filtre polyphase à n prises (2) et
- sortie du signal de données de sortie avec la seconde fréquence d'échantillonnage à une sortie (8).

- réception du signal de données d'entrée présentant la première fréquence d'échantillonnage à une entrée (7),
- filtrage des points d'échantillonnage du signal de données d'entrée avec un filtre polyphase à n prises (2), n étant un entier supérieur à 1.
- calcul des coefficients de filtre du filtre polyphase à n prises (2) à partir d'un signal de phase d'entrée avec une entité computationnelle (5,9)

Fig. 1

**Fig. 2**

**Fig. 3**

**Fig. 4**

**Fig. 5**

**Fig. 6**

**Fig. 7**

## REFERENCES CITED IN THE DESCRIPTION

### Patent documents cited in the description

- US 441320 A
- US 5907295 A
- US 5666299 A
- US 5638010 A

### Non-patent literature cited in the description

- A Stereo Asynchronous Digital Sample-Rate Converter for Digital Audio. **ADAMS.** IEICE Transactions on Electronics. Institute of Electronics Information And Comm. Eng. Tokyo, 1994, vol. E77-C, 811-818